# EUROPEAN PATENT APPLICATION

(11) **EP 3 048 712 A2**
(43) Date of publication of application: **27.07.2016**
(21) Application number: 15187630.7
(22) Date of filing: 30.09.2015
(51) Int. Cl.: H02M 1/32, H02M 3/158

(54) **POWER SUPPLY WITH SELF-DIAGNOSIS AND PROTECTION SWITCH**

(30) Priority: 26.01.2015 JP 2015011911
(71) Applicant: Murata Manufacturing Co., Ltd., Nagaokakyo-shi, Kyoto 617-8555 (JP)
(72) Inventor: Shiji, Hajime, Kyoto, 617-8555 (JP); Uno, Yoshiyuki, Kyoto, 617-8555 (JP); Hirose, Shouhei, Kyoto, 617-8555 (JP); Mizushima, Yoshiaki, Kyoto, 617-8555 (JP)
(74) Representative: Zinnecker, Armin

(57) **Abstract**

A third switching element (S1) is connected between: a converter portion including first and second switching elements (Q1, Q2), an inductor (L1), and a capacitor (C1); and an external connection terminal to which a DC power supply is connected. In a first control state in which the third switching element is turned ON and the switching elements are turned ON and OFF, a voltage value at a connection point between the inductor and the third switching element is detected. If voltage value ≥ Vth1 is satisfied, a second control state is executed in which the third switching element is turned OFF and switching of the switching elements is controlled. If voltage value ≤ Vth2 is satisfied in the second control state, it is determined that abnormality of the DC power supply has occurred. If voltage value > Vth2 is satisfied, it is determined that abnormality of the converter portion has occurred.

## Description

### BACKGROUND OF THE INVENTION

### 1. Field of the Invention

The present invention relates to a power supply apparatus which steps up or down a DC voltage.

### 2. Description of the Related Art

Japanese Patent No. 5611302 discloses an abnormality determination method executed when abnormality occurs in a power supply apparatus such as a DC-DC converter connected to a DC power supply. In the determination method described in Japanese Patent No. 5611302, if a voltage detected at a predetermined position is less than a predetermined value, it is determined that an abnormality has occurred, that is, a circulation semiconductor element of the converter is in a short-circuit state or a switching element of the converter is in an open state.

In the power supply apparatus (DC-DC converter), the short-circuit or open abnormality of the element does not necessarily become a cause for voltage abnormality, and, for example, the DC power supply connected to the power supply apparatus may become a cause for voltage abnormality. However, in the determination method described in Japanese Patent No. 5611302, it is not possible to identify the DC power supply as a cause for voltage abnormality, and appropriate measures cannot be taken after voltage abnormality detection in some cases. In particular, if the DC power supply has overvoltage abnormality, an overvoltage is applied to the element, so that the element may be broken. Thus, it is necessary to take appropriate measures at the time of voltage abnormality.

### SUMMARY OF THE INVENTION

Therefore, an object of the present invention is to provide a power supply apparatus which is able to identify a cause for overvoltage abnormality.

According to preferred embodiments of the present invention, a power supply apparatus includes: a first connection portion to which a first DC power supply is connected; a second connection portion to which a second DC power supply is connected; a first switching element and a second switching element sequentially connected in series between the first connection portion and ground; an inductor and a capacitor sequentially connected in series between a connection point between the first switching element and the second switching element and the ground; a third switching element connected between a connection point between the inductor and the capacitor and the second connection portion; a voltage detection unit configured to detect a voltage at a connection point between the inductor and the third switching element; a control unit configured to execute a first control state in which the third switching element is turned ON and at least one of the first switching element and the second switching element is turned ON and OFF; and execute a second control state in which the third switching element is turned OFF and the first switching element or the second switching element that has been turned ON and OFF in the first control state is turned ON and OFF, if a voltage detected by the voltage detection unit in the first control state is equal to or higher than a first threshold; and a determination unit configured to determine that abnormality has occurred at the second connection portion side with respect to the third switching element, if a voltage detected by the voltage detection unit in the second control state is equal to or lower than a second threshold; and determine that abnormality has occurred at the first connection portion side with respect to the third switching element, if the voltage is higher than the second threshold.

With this configuration, it is possible to determine that a cause for overvoltage abnormality is between the first connection portion and the third switching element (a converter portion) or the second DC power supply connected to the second connection portion, and thus it is possible to take appropriate measures after abnormality detection. In addition, when an overvoltage is detected, the third switching element between the second DC power supply and the inductor is turned OFF, whereby it is possible to prevent the overvoltage from being applied to the second DC power supply or the inductor, and thus it is possible to prevent element breakage or the like.

Preferably, if the determination unit determines that abnormality has occurred at the first connection portion side with respect to the third switching element, the control unit executes a third control state in which the first switching element or the second switching element that has been turned ON and OFF in the second control state is turned OFF; if a voltage detected by the voltage detection unit in the third control state is equal to or higher than a third threshold, the determination unit determines that abnormality of the first switching element has occurred; and if the voltage is less than the third threshold, the determination unit determines that abnormality of a control system has occurred.

With this configuration, if it is determined that a cause for overvoltage abnormality is the converter portion, it is possible to further determine the abnormality is abnormality of the first switching element or abnormality of the control system. The abnormality of the control system is, for example, a case where a duty ratio of the first switching element and the second switching element is abnormal. Thus, it is possible to take further appropriate measures after abnormality detection.

Preferably, the third switching element is a bidirectional switching element including two MOS-FETs connected such that directions of body diodes thereof are opposite to each other.

With this configuration, even when the MOS-FETs are OFF, since the directions of the body diodes of the two MOS-FETs are opposite to each other, it is possible to prevent a current from flowing from the first DC power supply to the second DC power supply or flowing in the opposite direction.

Other features, elements, characteristics and advantages of the present invention will become more apparent from the following detailed description of preferred embodiments of the present invention with reference to the attached drawings.

### BRIEF DESCRIPTION OF THE DRAWINGS

Fig. 1 is a circuit diagram of a power supply apparatus according to Embodiment 1;
Fig. 2 is a flowchart of a process of determining overvoltage abnormality of the power supply apparatus;
Fig. 3 is a flowchart of the process of determining overvoltage abnormality of the power supply apparatus; and
Fig. 4 is a circuit diagram of a power supply apparatus according to Embodiment 2.

### DESCRIPTION OF THE PREFERRED EMBODIMENTS

### Embodiment 1

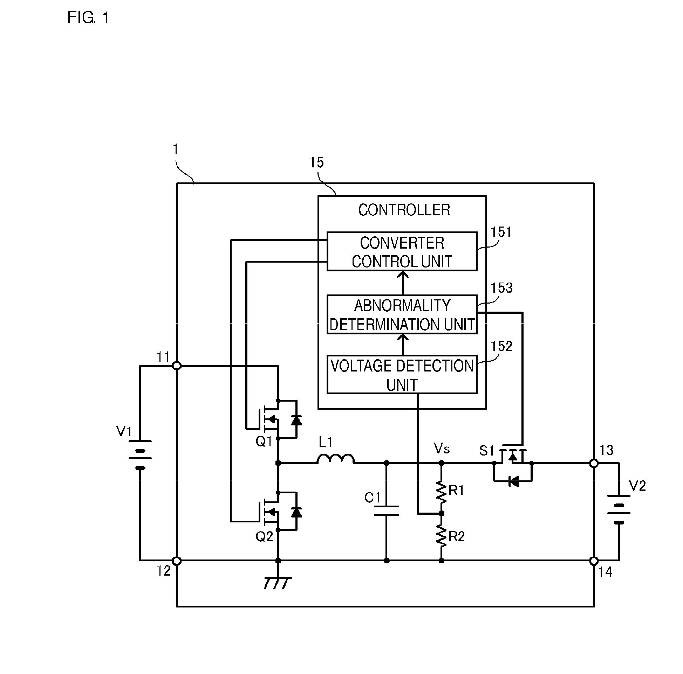

Fig. 1 is a circuit diagram of a power supply apparatus 1 according to Embodiment 1.

The power supply apparatus 1 includes external connection terminals 11, 12, 13, and 14. A DC power supply V1 is connected to the external connection terminals 11 and 12. A DC power supply V2 is connected to the external connection terminals 13 and 14. A connection line between the external connection terminals 12 and 14 is connected to ground. In the present embodiment, the power supply apparatus 1 is described as a step-down converter which steps down a DC voltage inputted through the external connection terminals 11 and 12 and outputs the stepped-down voltage from the external connection terminals 13 and 14.

The DC power supply V1 corresponds to a "first DC power supply" according to the present invention. The DC power supply V2 corresponds to a "second DC power supply" according to the present invention. In addition, the external connection terminal 11 corresponds to a "first connection portion" according to the present invention, and the external connection terminal 13 corresponds to a "second connection portion" according to the present invention.

Switching elements Q1 and Q2 are sequentially connected in series to the external connection terminals 11 and 12. The switching elements Q1 and Q2 are MOS-FETs. The switching element Q1 corresponds to a "first switching element" according to the present invention. The switching element Q2 corresponds to a "second switching element" according to the present invention. The switching element Q2 may be a diode. In this case, the cathode of the diode is connected to the switching element Q1.

An inductor L1 and a capacitor C1 are sequentially connected in series to a connection terminal of the switching elements Q1 and Q2. A connection point between the inductor L1 and the capacitor C1 is connected to the external connection terminal 13 via a switching element S1. The switching element S1 is a MOS-FET and corresponds to a "third switching element" according to the present invention.

The power supply apparatus 1 includes a controller 15. The controller 15 includes a converter control unit 151, a voltage detection unit 152, and an abnormality determination unit 153.

The converter control unit 151 controls switching of the switching elements Q1 and Q2 to step down the DC voltage inputted through the external connection terminals 11 and 12. In the case where the switching element Q2 is a diode, the converter control unit 151 controls switching of only the switching element Q1.

The voltage detection unit 152 detects a voltage at a connection point between the inductor L1 and the switching element S1, that is, a voltage value Vs of the DC voltage stepped down by a converter operation. Voltage-dividing resistors R1 and R2 connected in series are connected in parallel to the capacitor C1. The voltage detection unit 152 detects the voltage value Vs on the basis of voltages detected by the voltage-dividing resistors R1 and R2.

The abnormality determination unit 153 determines presence/absence of overvoltage abnormality of the power supply apparatus 1 and a cause for overvoltage abnormality. The abnormality determination unit 153 turns ON the switching element S1 at normal time. In a state where the switching element S1 is ON, the converter control unit 151 controls switching of the switching elements Q1 and Q2. By so doing, the DC voltage inputted through the external connection terminals 11 and 12 is stepped down and outputted from the external connection terminals 13 and 14. Hereinafter, this state is referred to as a first control state. In the first control state, the power supply apparatus 1 performs normal step-down operation.

In the first control state, the abnormality determination unit 153 determines whether the voltage value Vs detected by the voltage detection unit 152 is equal to or higher than a threshold Vth1. The threshold Vth1 is a voltage value at which a problem due to an overvoltage is caused in the power supply apparatus 1. The threshold Vth1 is set on the basis of the withstand voltage of each element forming the power supply apparatus 1. If the voltage value Vs is equal to or higher than the threshold Vth1, the abnormality determination unit 153 determines that overvoltage abnormality has occurred, and turns OFF the switching element S1. By turning OFF the switching element S1, if overvoltage abnormality has occurred due to abnormality of the switching element Q1 or converter control, an overcurrent flows to the external connection terminals 13 and 14, whereby it is possible to prevent stress at the time of abnormality from being applied to the DC power supply V2.

In a state where the switching element S1 is OFF, the converter control unit 151 controls switching of the switching elements Q1 and Q2. Hereinafter, this state is referred to as a second control state. In the second control state, the voltage detection unit 152 detects the voltage value Vs. The abnormality determination unit 153 determines whether the voltage value Vs is equal to or lower than a threshold Vth2. The threshold Vth2 is set on the basis of an output setting voltage value of the converter, a voltage range in which the DC power supply V2 normally operates, or the like. If the DC power supply V2 is a cause for overvoltage abnormality, the voltage value Vs is high due to influence of the DC power supply V2. By turning OFF the switching element S1, the influence is eliminated, so that the voltage value Vs lowers. Therefore, if the voltage value Vs is equal to or lower than the threshold Vth2, the abnormality determination unit 153 determines that the external connection terminals 13 and 14 side, that is, the DC power supply V2, is a cause for overvoltage abnormality.

If the voltage value Vs is not equal to or lower than the threshold Vth2, the converter control unit 151 stops control of switching of the switching elements Q1 and Q2 and turns OFF the switching elements Q1 and Q2. Hereinafter, this state is referred to as a third control state. In the third control state, the voltage detection unit 152 detects the voltage value Vs. The abnormality determination unit 153 determines whether the voltage value Vs detected by the voltage detection unit 152 is equal to or higher than a threshold Vth3. The threshold Vth3 is set, for example, on the basis of the voltage of the DC power supply V1, or the like. For example, if the switching element Q1 is broken due to short circuit (a conduction state occurs between the drain and the source even when a positive gate voltage is applied), the voltage of the DC power supply V1 is outputted from the converter. Thus, if the voltage value Vs is equal to or higher than the threshold Vth3, the abnormality determination unit 153 determines that breakage of the switching element Q1 due to short circuit is a cause for overvoltage abnormality. Specifically, even when the switching element Q1 is OFF, since the voltage value Vs is high, the abnormality determination unit 153 determines that overvoltage abnormality has occurred due to short-circuit breakage of the switching element Q1.

If the voltage value Vs is less than the threshold Vth3, the abnormality determination unit 153 determines that abnormality of a control system has occurred. The abnormality of the control system is, for example, abnormality of a duty ratio of converter control, a problem of feedback control (abnormality of a voltage monitoring line), or the like.

Since it is possible to identify which the DC power supply V2, the switching element Q1, or the control system is a cause for overvoltage abnormality as described above, it is possible to take appropriate measures after overvoltage abnormality detection. For example, it is possible to prevent a wasted operation of reviewing settings of the control system after overvoltage detection even if there is no abnormality in the control system. In addition, it is possible to prevent the switching element Q1 or the DC power supply V2 from being replaced even if there is no abnormality in these parts.

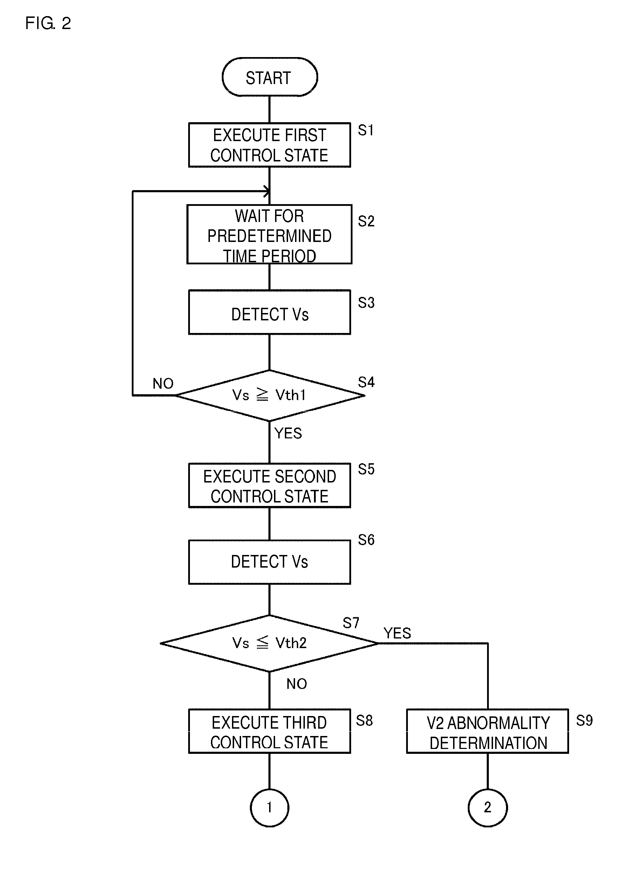

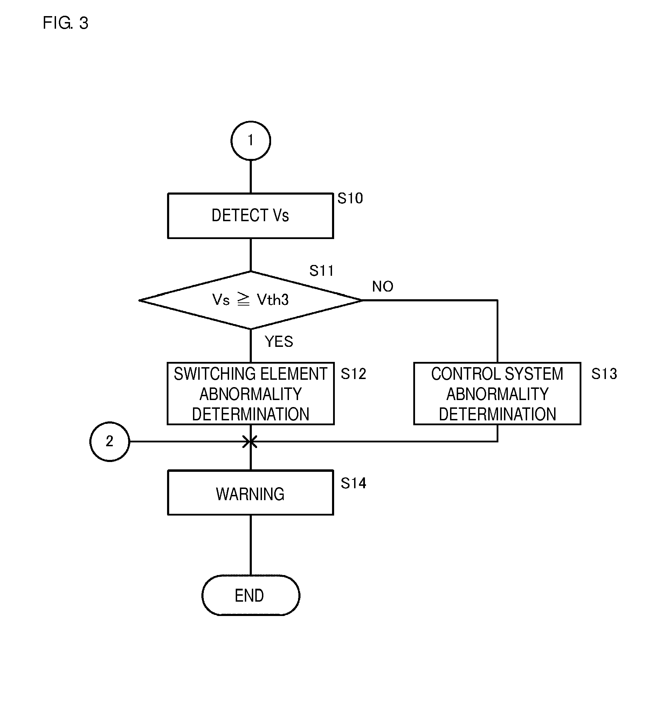

Figs. 2 and 3 are flowcharts of a process of determining overvoltage abnormality of the power supply apparatus 1. The process shown in Figs. 2 and 3 is executed by the controller 15.

The controller 15 executes the first control state (S1). That is, in a state where the switching element S1 is ON, the converter control unit 151 controls switching of the switching elements Q1 and Q2. By so doing, the DC voltage inputted through the external connection terminals 11 and 12 is stepped down and outputted from the external connection terminals 13 and 14. Next, the controller 15 waits for a predetermined time period (e.g., 10 ms) (S2). Thereafter, the voltage detection unit 152 detects the voltage value Vs (S3).

The abnormality determination unit 153 determines whether the voltage value Vs is equal to or higher than the threshold Vth1 (Vs ≥ Vth1) (S4). If Vs ≥ Vth1 is not satisfied (S4: NO), the controller 15 executes the process in S2 again. If Vs ≥ Vth1 is satisfied (S4: YES), the abnormality determination unit 153 turns OFF the switching element S1 and executes the second control state (S5). The voltage detection unit 152 detects the voltage value Vs (S6), and the abnormality determination unit 153 determines whether the voltage value Vs is equal to or lower than the threshold Vth2 (Vs ≤ Vth2) (S7).

If Vs ≤ Vth2 is satisfied (S7: YES), the abnormality determination unit 153 determines that overvoltage abnormality of the DC power supply V2 has occurred (S9). Thereafter, for example, the controller 15 issues a warning by status abnormality or the like (S14), and ends this process.

If Vs ≤ Vth2 is not satisfied (S7: NO), the converter control unit 151 turns OFF the switching elements Q1 and Q2 and executes the third control state (S8). The voltage detection unit 152 detects the voltage value Vs (S10), and the abnormality determination unit 153 determines whether the voltage value Vs is equal to or higher than the threshold Vth3 (Vs ≥ Vth3) (S11).

If Vs ≥ Vth3 is satisfied (S11: YES), the abnormality determination unit 153 determines that overvoltage abnormality has occurred due to short-circuit breakage of the switching element Q1 (S12). If Vs ≥ Vth3 is not satisfied (S11: NO), the abnormality determination unit 153 determines that abnormality of the control system has occurred (S13). After the determination in S12 or S13, the controller 15 issues a warning (S14) and ends this process. The warning executed in S14 is performed, for example, with a lamp.

Although the power supply apparatus 1 has been described as a step-down converter in the present embodiment, the power supply apparatus 1 may be a step-up converter which steps up a DC voltage inputted through the external connection terminals 13 and 14. In this case as well, the controller 15 detects the voltage value Vs between the inductor L1 and the switching element S1 to determine overvoltage abnormality. In this case, the abnormality determination unit 153 determines either overvoltage abnormality of the DC power supply V2 or overvoltage abnormality due to short-circuit breakage of the switching element Q1. In addition, in the case of a step-up converter, the switching element Q1 may be a diode. In this case, the converter control unit 151 controls switching of only the switching element Q2.

### Embodiment 2

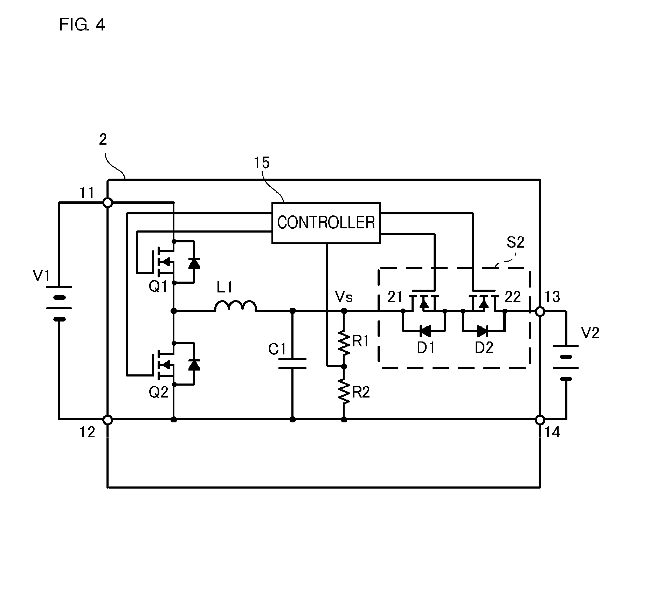

Fig. 4 is a circuit diagram of a power supply apparatus 2 according to Embodiment 2.

In this example, the switching element S2 connected between the inductor L1 and the external connection terminal 13 is a bidirectional switching element.

The switching element S2 includes two MOS-FETs 21 and 22. The MOS-FETs 21 and 22 are connected such that the directions of body diodes D1 and D2 thereof are opposite to each other. By making the directions of the body diodes D1 and D2 opposite to each other, it is possible to block a current flowing from the external connection terminals 13 and 14 to the inductor L1 when potential at the DC power supply V2 side is higher than that at the DC power supply V1 side. Thus, if overvoltage abnormality of the DC power supply V2 steadily occurs, it is possible to detect the voltage value Vs when the switching element S2 is turned OFF, without being affected by the overvoltage abnormality of the DC power supply V2, so that the abnormality determination unit 153 (see Fig. 1) is allowed to accurately determine overvoltage abnormality.

In addition, by blocking a current flowing from the external connection terminals 13 and 14 to the inductor L1, it is possible to prevent a current from flowing to the switching element Q2. As a result, it is possible to prevent element breakage at the time of abnormality.

The switching element S2 may be an IGBT (insulated gate bipolar transistor) not having a body diode formed therein, or a GaN-FET. In this case, it is possible to configure the switching element S2 as a single component, and thus space saving is achieved.

While preferred embodiments of the invention have been described above, it is to be understood that variations and modifications will be apparent to those skilled in the art without departing from the scope and spirit of the invention. The scope of the invention, therefore, is to be determined solely by the following claims.

## Claims

1. A power supply apparatus comprising:
a first connection portion to which a first DC power supply is connected;
a second connection portion to which a second DC power supply is connected;
a first switching element and a second switching element sequentially connected in series between the first connection portion and ground;
an inductor and a capacitor sequentially connected in series between a connection point between the first switching element and the second switching element and the ground;
a third switching element connected between a connection point between the inductor and the capacitor and the second connection portion;
a voltage detection unit configured to detect a voltage at a connection point between the inductor and the third switching element;
a control unit configured to execute a first control state in which the third switching element is turned ON and at least one of the first switching element and the second switching element is turned ON and OFF; and execute a second control state in which the third switching element is turned OFF and the first switching element or the second switching element that has been turned ON and OFF in the first control state is turned ON and OFF, if a voltage detected by the voltage detection unit in the first control state is equal to or higher than a first threshold; and
a determination unit configured to determine that abnormality has occurred at the second connection portion side with respect to the third switching element, if a voltage detected by the voltage detection unit in the second control state is equal to or lower than a second threshold; and determine that abnormality has occurred at the first connection portion side with respect to the third switching element, if the voltage is higher than the second threshold.

2. The power supply apparatus according to Claim 1,
wherein
if the determination unit determines that abnormality has occurred at the first connection portion side with respect to the third switching element, the control unit executes a third control state in which the first switching element or the second switching element that has been turned ON and OFF in the second control state is turned OFF, and
if a voltage detected by the voltage detection unit in the third control state is equal to or higher than a third threshold, the determination unit determines that abnormality of the first switching element has occurred, and if the voltage is less than the third threshold, the determination unit determines that abnormality of a control system has occurred.

3. The power supply apparatus according to Claim 1 or 2, wherein the third switching element is a bidirectional switching element including two MOS-FETs connected such that directions of body diodes thereof are opposite to each other.
